## Europäisches Patentamt

## European Patent Office

## Office européen des brevets

(19)

(11) EP 0 578 098 B1

(12) **EUROPÄISCHE PATENTSCHRIFT**

(45) Veröffentlichungstag und Bekanntmachung des Hinweises auf die Patenterteilung:
**04.09.1996 Patentblatt 1996/36**

(51) Int Cl.⁶: **H03K 17/66**, H03F 3/217

(21) Anmeldenummer: **93110318.8**

(22) Anmeldetag: **29.06.1993**

(54) **Integrierbare Treiberschaltung für eine reaktive Last**

Integrated driver circuit for a reactive load

circuit de commande intégré pour une charge réactive

(84) Benannte Vertragsstaaten:
**DE ES FR GB IT**

(30) Priorität: **07.07.1992 DE 4222281**

(43) Veröffentlichungstag der Anmeldung:
**12.01.1994 Patentblatt 1994/02**

(73) Patentinhaber: **SIEMENS AKTIENGESELLSCHAFT**
**80333 München (DE)**

(72) Erfinder: **Erckert, Ricardo, Dipl.-Ing.**
**D-85617 Assling (DE)**

(56) Entgegenhaltungen:
FR-A- 2 560 407          US-A- 4 079 271
US-A- 4 645 945

## Beschreibung

Die Erfindung bezieht sich auf eine integrierbare Treiberschaltung für eine reaktive Last nach dem Oberbegriff des Patentanspruchs 1.

Treiberschaltungen für Lasten mit induktivem oder kapazitivem Verhalten (reaktive Lasten) weisen meist zwei Gegentaktendstufen in Brückenschaltung auf, um die zur Verfügung stehende Versorgungsspannung wirkungsvoll zu nutzen. Häufig wird darüber hinaus bei beiden Gegentaktendstufen jeweils ein Transistor in Kollektorschaltung und der jeweils andere in Emitterschaltung betrieben, um beispielsweise die Verwendung von Transistoren ausschließlich eines Leitungstyps zu ermöglichen. Den Emitter-Kollektor-Strecken dieser Transistoren sind zur Kommutierung jeweils Freilaufdioden parallel geschaltet. Zur ihrer Ansteuerung wird im allgemeinen jeweils ein Transistor eingesetzt, dessen Kollektor mit der Basis und dessen Emitter mit dem Kollektor des in Kollektorschaltung betriebenen Transistors der jeweiligen Gegentaktendstufe verbunden ist. An die über jeweils einen sogenannten Ausräumwiderstand mit ihren zugehörigen Emittern gekoppelten Basen der zur Ansteuerung vorgesehenen Transistoren sind entsprechende Steuersignale angelegt. Aufgrund der Basis-Emitter-Durchlaßspannung der in Kollektorschaltung betriebenen Transistoren und des daraus resultierenden Spannungsabfalls an ihren Emitter-Kollektor-Strecken ist bei dieser Art der Ansteuerung der Spannungshub an der Last jedoch eingeschränkt.

Um dem entgegenzuwirken, ist etwa bei dem handelsüblichen integrierten Schaltkreis PBL 3717 der Firma Ericson zur Ansteuerung beider Gegentaktendstufen zusätzlich jeweils ein Transistor enthalten, dessen Kollektor mit der Basis des zur Ansteuerung der jeweiligen Gegentaktendstufe vorgesehenen Transistors und dessen Emitter mit dem Emitter des in Kollektorschaltung betriebenen Transistors der jeweils anderen Gegentaktendstufe verbunden ist. An die Basen der zusätzlichen Transistoren sind die Steuersignale entsprechend angelegt. Hierbei wird zur Versorgung der zusätzlichen Transistoren zudem der durch die reaktive Last erzeugte Spannungsabfall über der Freilaufdiode des in Kollektorschaltung betriebenen Transistors der jeweils anderen Gegentaktendstufe verwendet. Dadurch wird das Emitterpotential der zusätzlichen Transistoren und demzufolge auch das Basispotential der in Kollektorschaltung betriebenen Transistoren entsprechend angehoben, so daß der Spannungsabfall an den Emitter-Kollektor-Strecken der zuletzt genannten Transistoren minimal wird und sich ein Spannungshub an der Last von annähernd dem doppelten der Versorgungsspannung ergibt.

Insbesondere bei einer Realisierung in integrierter Schaltungstechnik dürfen jedoch für die zusätzlichen Transistoren keine Ausräumwiderstände vorgesehen werden, da ansonsten bei bestimmten Betriebszuständen durch die Kollektoren und Basen der zusätzlichen Transistoren zusammen mit dem Substrat gebildete parasitäre Transistorstrukturen durchgeschaltet würden, was zu Fehlfunktionen oder zur Zerstörung des Schaltkreises führen würde.

Durch das Fehlen von Ausräumwiderständen bei den zusätzlichen Transistoren können diese jedoch nur vergleichsweise langsam abgeschaltet werden, was zu Einbussen bei der Flankensteilheit im Schaltbetrieb und unter Umständen zu Querströmen zwischen den Gegentaktendstufen führen kann.

Aufgabe der Erfindung ist es, eine integrierte Treiberschaltung für reaktive Lasten der eingangs genannten Art anzugeben, die diese Nachteile nicht aufweist.

Diese Aufgabe wird bei einer gattungsgemäßen Treiberschaltung durch die kennzeichnenden Merkmale des Patentanspruches 1 gelöst.

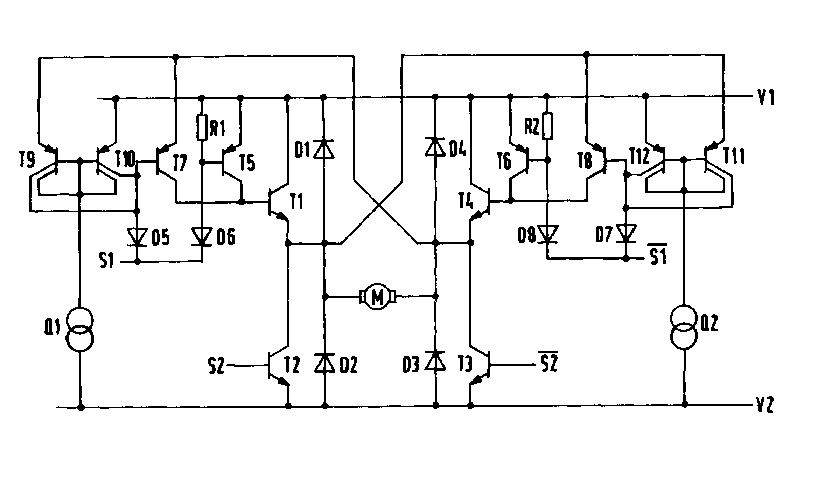

Die Erfindung wird nachfolgend anhand des in der einzigen Figur der Zeichnung dargestellten Ausführungsbeispiels näher erläutert.

Bei der in der Zeichnung gezeigten integrierbaren Treiberschaltung sind zwei Gegentaktendstufen vorgesehen, die jeweils einen npn-Transistor T1 bzw. T4 in Kollektorschaltung und einen npn-Transistor T2 bzw. T3 in Emitterschaltung aufweisen. Die beiden Gegentaktendstufen werden in Brückenschaltung betrieben. Dabei liegen die Kollektoren der npn-Transistoren T1 und T4 an einem positiven Versorgungspotential V1 und die Emitter der npn-Transistoren T2 und T3 an einem negativen Versorgungspotential V2. Der Emitter des npn-Transistors T1 ist zum einen mit dem Kollektor des npn-Transistors T2 und zum anderen mit einem Anschluß einer reaktiven Last, beispielsweise einem Schrittmotor M, verschaltet. Der andere Anschluß der Last ist mit dem Emitter des npn-Transistors T4 und mit dem Kollektor des npn-Transistors T3 verbunden. Außerdem sind den Emitter-Kollektor-Strecken der Transistoren T1 bis T4 jeweils Freilaufdioden D1 bis D4 in Sperrichtung parallelgeschaltet. Die beiden npn-Transistoren T2 und T3 in Emitterschaltung können aber in gleicher Weise durch pnp-Transistoren in Kollektorschaltung ersetzt werden.

Zur Ansteuerung des npn-Transistors T1 ist ein pnp-Transistor T5, dessen Emitter mit dem Kollektor und dessen Kollektor mit der Basis des npn-Transistors T1 verbunden ist, sowie ein pnp-Transistor T7, dessen Kollektor mit der Basis des npn-Transistors T1 und dessen Emitter mit dem Emitter des npn-Transistors T4 verbunden ist, vorgesehen. Dementsprechend ist die Basis des npn-Transistors T4 zum einen mit dem Kollektor eines pnp-Transistors T6, dessen Emitter mit dem Kollektor des npn-Transistors T4 verschaltet ist, und zum anderen mit dem Kollektor eines pnp-Transistors T8, dessen Emitter an den Emitter des npn-Transistors T1 angeschlossen ist, verbunden. An die Basen der pnp-Transistoren T7 und T5 ist über jeweils eine Diode D5 bzw. D6 ein Steuersignal S1 angelegt. Ein dazu gegenphasiges Steuersignal $\overline{S1}$ ist demzufolge über jeweils eine Diode D7 bzw. D8 an die Basen der pnp-Transistoren T6 und T8 gelegt. Die Basis des npn-Transistors T2 wird durch ein zum Signal S1 gleichphasiges Signal S2 und die Basis des npn-Transistors T3 durch ein zum Signal $\overline{S1}$ gleichphasiges Signal 52 angesteuert. Schließlich ist bei den pnp-Transistoren T5 und T6 zwischen Basis und Emitter jeweils ein als Ausräumwiderstand wirkender Widerstand R1 bzw. R2 geschaltet.

Erfindungsgemäß sind zwei Stromspiegel vorgesehen, deren jeweiliger Ausgangskreis zwischen die Basis des pnp-Transistors T7 und den Emitter des npn-Transistors T4 bzw. zwischen die Basis des pnp-Transistors T7 und das positive Versorgungspotential V1 geschaltet ist. Die Eingangskreise der beiden Stromspiegel werden durch eine gemeinsame Stromquelle Q1 gespeist. Darüber hinaus sind zwei weitere, durch eine Stromquelle Q2 eingangsseitig gespeiste Stromspiegel enthalten, deren jeweiliger Ausgangskreis dementsprechend zwischen die Basis des pnp-Transistors T8 und den Emitter des npn-Transistors T1 bzw. zwischen die Basis des pnp-Transistors T8 und das positive Versorgungspotential V1 geschaltet ist. Beim vorliegenden Ausführungsbeispiel werden die einzelnen Stromspiegel durch jeweils einen pnp-Doppelkollektor-Transistor T9 bzw. T10 bzw. T11 bzw. T12 gebildet. Dabei ist jeweils einer der Kollektoren des pnp-Transistors T9 bzw. T11 sowie dessen Basis mit einem der Kollektoren des pnp-Transistors T10 bzw. T12 sowie dessen Basis verbunden und über die jeweilige Stromquelle Q1 bzw. Q2 an das negative Versorgungspotential V2 angeschlossen. Die jeweils anderen Kollektoren der pnp-Transistoren T9 und T10 bzw. T11 und T12 sind mit der Basis des pnp-Transistors T7 bzw. T8 verschaltet. Die Emitter der pnp-Transistoren T10 und T12 sind an das positive Versorgungspotential V1 gelegt, während der Emitter des pnp-Transistors T9 mit dem Emitter des npn-Transistors T4 und der Emitter des pnp-Transistors T11 mit dem Emitter des npn-Transistors T1 verbunden ist. Neben der gezeigten Ausführungsform der Stromspiegel sind jedoch auch alle anderen Arten von Stromspiegeln einsetzbar.

Aufgrund der Stromspiegel werden die pnp-Transistoren T7 und T8 unter allen Betriebsbedingungen ausgeräumt, wodurch sich die Abschaltzeiten erheblich verkürzen. Ein ungewolltes Durchschalten parasitärer Transistorstrukturen tritt dabei jedoch nicht auf. Zudem können vorteilhafterweise die beiden pnp-Transistoren T7 und T8 bis zur Kollektor-Emitter-Restspannung betrieben werden.

## Patentansprüche

1. Integrierbare Treiberschaltung für eine reaktive Last (M) mit einem ersten und zweiten Transistor (T1, T4), deren Kollektoren an ein erstes Versorgungspotential (V1) gelegt sind und deren Emitter über die Last (M) miteinander gekoppelt sind, mit einem dritten und vierten Transistor (T2, T3), deren jeweilige Emitter-Kollektor-Strecke zwischen ein zweites Versorgungspotential (V2) und den Emitter des ersten bzw. zweiten Transistors (T1, T4) geschaltet ist, mit vier Freilaufdioden (D1 bis D4), die jeweils zwischen Emitter und Kollektor von erstem, zweitem, drittem bzw. viertem Transistor (T1, T4, T2, T3) geschaltet sind, mit einem fünften und sechsten Transistor (T5, T6), deren Emitter an dem ersten Versorgungspotential (V1) liegen und deren jeweiliger Kollektor mit der Basis des ersten bzw. zweiten Transistors (T1, T4) verbunden ist, mit einem siebten Transistor (T7), dessen Kollektor mit der Basis des ersten Transistors (T1) und dessen Emitter mit dem Emitter des zweiten Transistors (T4) verbunden ist, mit einem achten Transistor (T8), dessen Kollektor mit der Basis des zweiten Transistors (T4) und dessen Emitter mit dem Emitter des ersten Transistors (T1) verbunden ist und dessen Basis gleichphasig zu den Basen von viertem und sechstem Transistor (T3, T6) sowie gegenphasig zu den Basen von drittem, fünftem und siebtem Transistor (T2, T5, T7) angesteuert wird, und mit jeweils einem Widerstand (R1, R2) zwischen Basis und Emitter von fünftem bzw. sechstem Transistor (T5, T6), **gekennzeichnet** durch einen ersten und zweiten Stromspiegel (T9, T10), deren jeweiliger Ausgangskreis zwischen die Basis des siebten Transistors (T7) und den Emitter des zweiten Transistors (T4) bzw. das erste Versorgungspotential (V1) geschaltet ist und deren Eingangskreise durch eine gemeinsame erste Stromquelle (Q1) gespeist werden, und durch einen dritten und vierten Stromspiegel (T11, T12), deren jeweiliger Ausgangskreis zwischen die Basis des achten Transistors (T8) und den Emitter des ersten Transistors (T1) bzw. das erste Versorgungspotential (V1) geschaltet ist und deren Eingangskreise durch eine gemeinsame zweite Stromquelle (Q2) gespeist werden.

## Claims

1. Integrated driver circuit for a reactive load (M), having a first and a second transistor (T1, T4), to the collectors of which a first supply potential (V1) is applied and the emitters of which are coupled together. through the load (M), having a third and a fourth transistor (T2, T3), the emitter/collector paths of which are each connected between a second supply potential (V2) and the emitter of the first and second transistor (T1, T4), respectively, having four freewheeling diodes (D1 to D4), which are each connected between the emitter and the collector of the first, second, third and fourth transistors (T1, T4, T2, T3), respectively, having a fifth and a sixth transistor (T5, T6), to the emitters of which the first supply potential (V1) is applied and the collectors of each of which are connected to the base of the first and second transistors (T1, T4), respectively, having a seventh transistor (T7), the collector of which is connected to the base of the first transistor (T1), and the emitter of which is connected to the emitter of the second transistor (T4), having an eighth transistor (T8), the connector of which is connected to the base of the second transistor (T4), and the emitter of which is connected to the emitter of the first transistor (T1), and the base of which is driven inphase with the bases of the fourth and sixth transistors (T3, T6) as well as in phase opposition to the bases of the third, fifth and seventh transistors (T2, T5, T7), and having in each case one resistor (R1, R2) between the base and emitter of the fifth and sixth transistors (T5, T6), respectively, characterized by first and second current mirrors (T9, T10), the output circuit of each of which is connected between the base of the seventh transistor (T7) and the emitter of the second transistor (T4) and the first supply potential (V1), respectively, and the input circuits of which are supplied by a common first current source (Q1), and by third and fourth current mirrors (T11, T12), the output circuit of each of which is connected between the base of the eighth transistor (T8) and the emitter of the first transistor (T1) and the first supply potential (V1), respectively, and the input circuits of which are supplied by a common current source (Q2).

**Revendications**

1. Circuit d'attaque, pouvant être intégré, pour une charge (M) réactive, comportant des premier et second transistors (T1, T4), dont les collecteurs sont portés à un premier potentiel (V1) d'alimentation et dont les émetteurs sont couplés l'un à l'autre par l'intermédiaire de la charge (M), des troisième et quatrième transistors (T2, T3), dont la section émetteur-collecteur respective est branchée entre un second potentiel (V2) d'alimentation et l'émetteur du premier ou second transistor (T1, T4), quatre diodes (D1 à D4) de roue libre, qui sont branchées respectivement entre l'émetteur et le collecteur des premier, deuxième, troisième et quatrième transistors (T1, T4, T2, T3), des cinquième et sixième transistors (T5, T6), dont les émetteurs sont au premier potentiel (V1) d'alimentation et dont le collecteur respectif est relié à la base du premier ou second transistor (T1, T4), un septième transistor (T7), dont le collecteur est relié à la base du premier transistor (T1) et dont l'émetteur est relié à l'émetteur du second transistor (T4), un huitième transistor (T8), dont le collecteur est relié à la base du second transistor (T4), dont l'émetteur est relié à l'émetteur du premier transistor (T1) et dont la base est commandée en phase avec les bases des quatrième et sixième transistors (T3, T6) et en opposition de phase avec les bases des troisième, cinquième et septième transistors (T2, T5, T7), et une résistance (R1, R2) entre la base et l'émetteur des cinquième et sixième transistors (T5, T6), caractérisé par des premier et second miroirs (T9, T10) de courant, dont le circuit de sortie est branché entre la base du septième transistor (T7) et l'émetteur du second transistor (T4) ou le premier potentiel (V1) d'alimentation et dont les circuits d'entrée sont alimentés par une première source (Q1) commune de courant, et par des troisième et quatrième miroirs (T11, T12) de courant, dont le circuit de sortie est branché entre la base du huitième transistor (T8) et l'émetteur du premier transistor (T1) ou le premier potentiel (V1) d'alimentation et dont les circuits d'entrée sont alimentés par une seconde source (Q2) commune de courant.